# EUROPEAN PATENT APPLICATION

(11) **EP 4 597 148 A1**
(43) Date of publication of application: **06.08.2025**
(21) Application number: 24154614.2
(22) Date of filing: 30.01.2024
(51) Int. Cl.: G01R 33/565, G01R 33/561, G01R 33/24, G01R 33/44, G01R 33/48

(54) **DIXON TYPE WATER/FAT SEPARATION MR IMAGING**

(71) Applicant: Koninklijke Philips N.V., 5656 AG Eindhoven (NL)
(72) Inventor: EGGERS, Holger, 5656AG Eindhoven (NL)
(74) Representative: Philips Intellectual Property & Standards

(57) **Abstract**

The invention relates to a method of MR imaging of an object (10) placed in a main magnetic field B0. It is an object of the invention to provide a method that enables an improved Dixon water/fat separation in combination with a multi-echo acquisition. The method of the invention comprises the following steps: The object (10) is subjected to an imaging sequence comprising multiple segments (S 1, S2), each segment comprising at least one RF pulse followed by a phase-encoding magnetic field gradient and a series of bipolar readout magnetic field gradients applied during a readout period. Two or more phase-encoded echo signals are acquired during each readout period, each of the echo signals being associated with a different echo time resulting from the application of the series of bipolar readout magnetic field gradients. The phase-encoding and bipolar readout magnetic field gradients are controlled so as to sample a pre-determined k-space region with both positive and negative, i.e. opposite, readout directions for each echo time. Amplitude and/or phase errors are estimated from the echo signals acquired with opposite readout directions for each echo time. Finally, an MR image is reconstructed for each echo time involving correction of image distortions according to the estimated amplitude and/or phase errors. Moreover, the invention relates to an MR system (1) and to a computer program.

## Description

### FIELD OF THE INVENTION

The invention relates to the field of magnetic resonance (MR) imaging. It concerns a method of MR imaging of an object placed in a main magnetic field B0. The invention also relates to an MR system and to a computer program to be run on an MR system.

### BACKGROUND OF THE INVENTION

Image-forming MR methods which utilize the interaction between magnetic fields and nuclear spins in order to form two-dimensional or three-dimensional images are widely used nowadays, notably in the field of medical diagnostics, because for the imaging of soft tissue they are superior to other imaging methods in many respects, do not require ionizing radiation and are usually not invasive.

In MR imaging, it is often desired to obtain information about the relative contribution of water and fat to the overall signal, either to suppress the contribution of one of them or to separately or jointly analyse the contribution of both of them. These contributions can be calculated if information from two or more corresponding echoes, acquired at different echo times (with respect to excitation or spin echo refocussing), is combined. This may be considered as chemical shift encoding, in which an additional dimension, the chemical shift dimension, is defined and encoded by acquiring two or more MR images at slightly different echo times. For water/fat separation, these types of experiments are often referred to as Dixon-type measurements. By means of Dixon MR imaging or Dixon water/fat MR imaging, a water/fat separation is achieved by calculating contributions of water and fat from two or more corresponding echoes, acquired at different echo times. In general such a separation is possible because there is a known precessional frequency difference of hydrogen in water and fat.

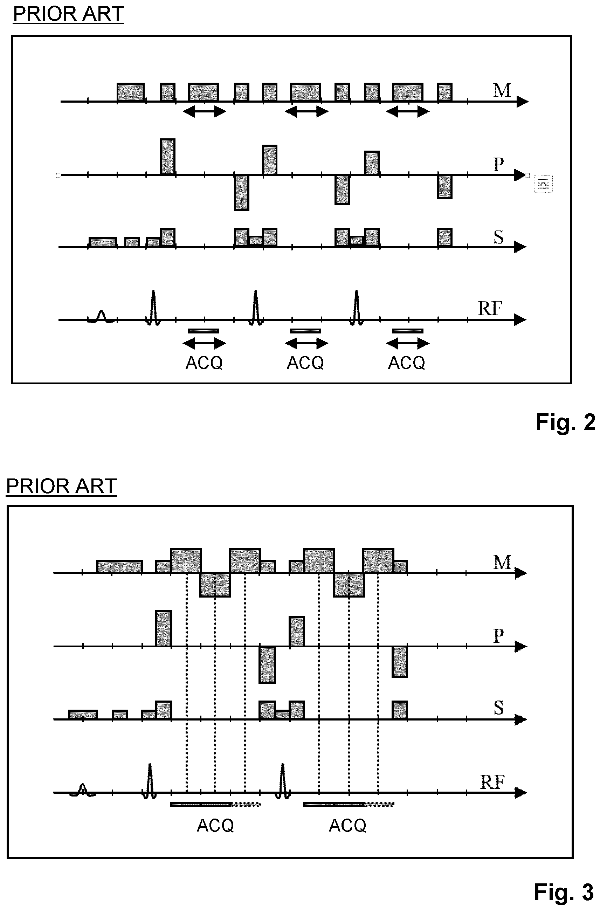

Dixon-type MR imaging methods can be applied in combination with fast (turbo) spin echo sequences using a multi-repetition approach. Typically, two or three interleaved measurements with shifted readout magnetic field gradients and acquisition windows are employed. In Fig. 2, a schematic pulse sequence diagram of a conventional turbo spin echo (TSE) Dixon sequence is depicted. The diagram shows switched magnetic field gradients in the frequency-encoding direction (M), the phase-encoding direction (P) and the slice-selection direction (S). Moreover, the diagram shows RF excitation and refocusing pulses as well as the time intervals during which echo signals are acquired, designated by ACQ. The diagram covers the acquisition of the first three echo signals of one shot of the imaging sequence. The double arrows indicate the shifting of the readout magnetic field gradients (top) and the acquisition windows ACQ (bottom) between multiple repetitions of one shot with identical phase encoding. According to the shifting of the readout magnetic field gradients, different phase offsets of the signal contributions from water protons and fat protons, respectively, are obtained on which the Dixon-type water/fat separation is based.

In comparison to standard (non-Dixon) TSE sequences, Dixon TSE techniques provide superior fat suppression and multiple contrasts in a single acquisition. However, because of the required multiple repetitions of each shot with identical phase encoding, scan time increases. Moreover, scan efficiency decreases due to the dead times introduced to permit shifting the readout magnetic field gradients and the acquisition windows. Alternatively, the echo spacing increases, and longer or more echo trains are needed. This results in less coverage and more blurring in the reconstructed MR images, or again in longer scan time.

Alternatively, a multi-echo approach is pursued, acquiring two or three echoes instead of one echo after each RF refocusing pulse. Ma et al. (Magnetic Resonance in Medicine, 58, 103-109, 2007) describe a triple-echo Dixon TSE technique, in which three echo signals are generated in each time interval between two consecutive refocusing RF pulses. The echo signals are acquired using a bipolar triplet of readout magnetic field gradients in order to reduce the temporal spacing between these three echo signals and thus the time interval between two consecutive refocusing RF pulses and the T2 decay over the echo trains. Fig. 3 shows an example of this approach. A pulse sequence diagram of a triple-echo Dixon TSE sequence is depicted, covering the acquisition of the first two echo signal triplets of one shot. Three gradient-recalled echoes are acquired after each RF refocusing pulse. The bipolar triplet of readout magnetic field gradients is preceded and succeeded by spoiler readout magnetic field gradients. The vertical dashed lines indicate the different echo times.

In order to be efficient, the multi-echo approach has to rely on bipolar readout magnetic field gradients as shown in Fig. 3. The readout magnetic field gradients have alternating positive and negative lobes of equal strengths such that different (positive and negative) readout directions of the acquired echo signals are associated with the different echo times. This entails that off-resonance effects, due to chemical shift or inhomogeneity of the main magnetic field B0, lead to distortions in opposite directions in the resulting single-echo images. In addition, eddy currents cause phase errors between the single-echo images. In quantitative applications, such as fat quantification (proton density fat fraction quantification) and quantitative susceptibility mapping, phase and amplitude variations between odd and even echoes as well as distortions in opposite directions due to B0 inhomogeneity lead to bias.

### SUMMARY OF THE INVENTION

It is an object of the invention to provide a method that enables a further improved Dixon water/fat separation in combination with a multi-echo acquisition.

In accordance with the invention, a method of MR imaging of an object placed in in a main magnetic field B0 is disclosed. The method comprises the steps of:
- subjecting the object to an imaging sequence comprising multiple segments, each segment comprising at least one RF pulse followed by a phase-encoding magnetic field gradient and a series of bipolar readout magnetic field gradients applied during a readout period,
- acquiring two or more phase-encoded echo signals during each readout period, each of the echo signals being associated with a different echo time resulting from the application of the series of bipolar readout magnetic field gradients, the phase-encoding and bipolar readout magnetic field gradients being controlled so as to sample a pre-determined k-space region with both positive and negative, i.e. opposite, readout directions for each echo time,
- estimating amplitude and/or phase errors from the echo signals acquired with opposite readout directions for each echo time, and
- reconstructing an MR image for each echo time involving correction of image distortions according to the estimated amplitude and/or phase errors.

According to the invention, a multi-echo imaging sequence with bipolar readout gradients is used. In contrast to the conventional approach, the echo signals are acquired with different readout magnetic field gradient polarities for each echo time. Hence, amplitude and phase errors can be estimated from the echo signals acquired with opposite readout directions for each echo time. This prevents that the estimation of the amplitude and phase errors confounds the determination of true amplitude and phase variations between different echo times on which water/fat separation, fat quantification or susceptibility-weighted imaging rely.

For each echo time, an individual MR image can be reconstructed for each readout direction. Amplitude and/or phase errors caused by the bipolar readout can then be estimated from the pair of individual MR images by aligning the voxel-wise amplitude and phase of the image pair.

A water/fat separation can be performed on the basis of each set of individual MR images reconstructed for the same readout direction at different echo times. The amplitude and/or phase errors can be estimated in this case from the resulting water and fat images (or combinations thereof after a fat shift correction). Amplitude and/or phase errors can be by-products of the water/fat separation algorithm, in particular if echo signals are acquired at a sufficient number of echo times.

In another embodiment, single-echo MR images can be reconstructed from the acquired echo signals, i.e. the full data set including echo signals acquired with both readout directions for the different echo times, and corrected for the previously estimated phase and amplitude errors. The thus corrected single-echo images can then be used for water/fat separation, proton density fat quantification, or (quantitative) susceptibility mapping.

It has to be noted that the formulation "correction of image distortions" used herein is to be understood in the broadest possible sense. It is in particular not restricted to the correction of spatial shifts of image contents but relates to the correction of any conceivable image deterioration or image artefact caused by amplitude and/or phase errors.

In a possible embodiment, for each echo time, the readout direction for sampling one half of the pre-determined k-space region is positive, while the readout direction for sampling the other half of the pre-determined k-space region is negative. Preferably, the sampling of the pre-determined k-space region is performed for each echo time in such a way that the echo signals succeeding in the phase encoding direction have alternating positive and negative readout directions. In this way, k-space lines with positive and negative readout directions are sampled in an interleaved fashion which facilitates the reconstruction of an individual MR image for each readout direction for the purpose of estimating the phase and amplitude errors for each echo time.

In yet another embodiment, the method further comprises a B0 mapping step, wherein the reconstruction of the MR images involves a correction of distortions arising from B0 inhomogeneity. The separate determination of B0 inhomogeneity improves the quality of the water/fat separation, fat quantification or susceptibility mapping respectively.

In a possible embodiment, the water/fat separation can be used to provide the B0 map. The determination of B0 at each voxel location can be a by-product of the water/fat separation algorithm, in particular if echo signals are acquired at a sufficient number of echo times.

The method of the invention described thus far can be carried out by means of an MR system including at least one main magnet coil for generating an essentially uniform, static magnetic field B0 within an examination volume, a number of gradient coils for generating switched magnetic field gradients in different spatial directions within the examination volume, at least one body RF coil for generating RF pulses within the examination volume and/or for receiving MR signals from a body of a patient positioned in the examination volume, a control unit for controlling the temporal succession of RF pulses and switched magnetic field gradients, and a reconstruction unit for reconstructing MR images from the received MR signals. The method of the invention can be implemented by a corresponding programming of the reconstruction unit and/or the control unit of the MR system.

The method of the invention can be advantageously carried out on most MR systems in clinical use at present. To this end it is merely necessary to utilize a computer program by which the MR system is controlled such that it performs the above-explained method steps of the invention. The computer program may be present either on a data carrier or be present in a data network so as to be downloaded for installation in the control unit of the MR system. The post-processing of the acquired echo signal data (including the estimation of phase and amplitude errors, the reconstruction of single-echo MR images and/or water/fat separation) may also be performed on a computer which is separate from the MR system used for acquisition of the echo signals.

### BRIEF DESCRIPTION OF THE DRAWINGS

The enclosed drawings disclose preferred embodiments of the present invention. It should be understood, however, that the drawings are designed for the purpose of illustration only and not as a definition of the limits of the invention. In the drawings:
Fig. 1 shows an MR system for carrying out the method of the invention;
Fig. 2 shows a schematic (simplified) pulse sequence diagram of a conventional multi-repetition TSE Dixon imaging sequence;
Fig. 3 shows a schematic (simplified) pulse sequence diagram of a conventional multi-echo TSE Dixon imaging sequence using bipolar readout magnetic field gradients;
Fig. 4 shows k-space diagrams illustrating the sampling of k-space for different echo times according to the invention;
Fig. 5 shows a schematic (simplified) pulse sequence diagram according to an embodiment of the invention; and
Fig. 6 shows a flow chart illustrating a possible implementation of the method according to the invention.

### DETAILED DESCRIPTION OF EMBODIMENTS

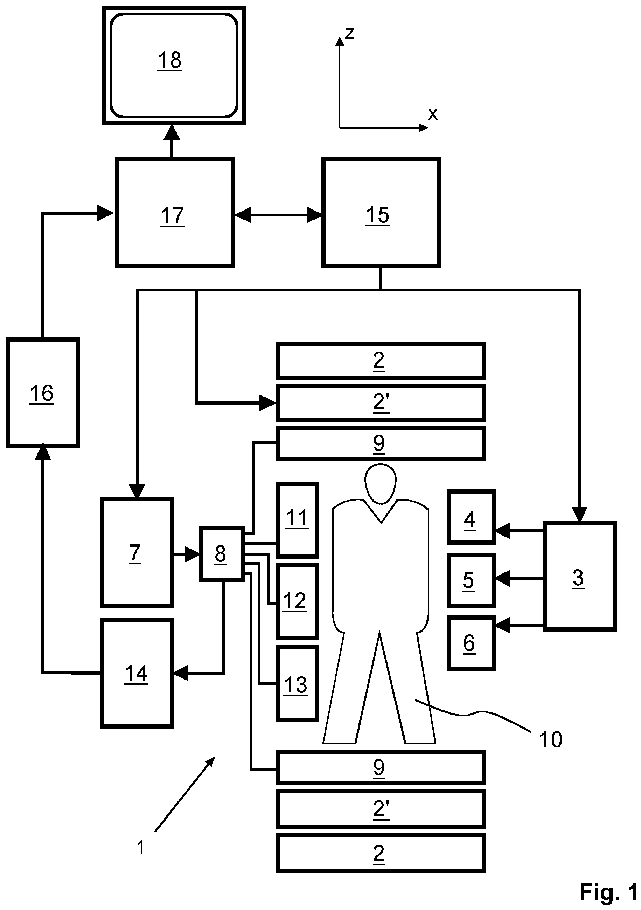

With reference to Fig. 1, an MR system 1 is shown as a block diagram. The device comprises superconducting or resistive main magnet coils 2 such that a substantially uniform, temporally constant main magnetic field B0 is created along a z-axis through an examination volume. The device further comprises a set of (1st, 2nd, and - where applicable - 3rd order) shimming coils 2', wherein the current flow through the individual shimming coils of the set 2' is controllable for the purpose of minimizing B0 deviations within the examination volume.

A magnetic resonance generation and manipulation system applies a series of RF pulses and switched magnetic field gradients to invert, excite, saturate, refocus, and spatially and otherwise encode the magnetic resonance to perform MR imaging.

More specifically, a gradient pulse amplifier 3 applies current pulses to selected ones of whole-body gradient coils 4, 5 and 6 along x, y and z-axes of the examination volume. A digital RF frequency transmitter 7 transmits RF pulses or pulse packets, via a send/receive switch 8, to a body RF coil 9 to transmit RF pulses into the examination volume. A typical MR imaging sequence is composed of a packet of RF pulse segments of short duration which, together with any applied magnetic field gradients, achieve a selected manipulation of nuclear magnetic resonance. In particular, the RF pulses select a portion of a body 10 positioned in the examination volume. The MR signals are also picked up by the body RF coil 9.

For generation of MR images of limited regions of the body 10, a set of local array RF coils 11, 12, 13 are placed contiguous to the region selected for imaging. The array coils 11, 12, 13 can be used to receive MR signals induced by transmissions of the body RF coil.

The resultant MR signals are picked up by the body RF coil 9 and/or by the array RF coils 11, 12, 13 and demodulated by a receiver 14 preferably including a preamplifier (not shown). The receiver 14 is connected to the RF coils 9, 11, 12 and 13 via the send/receive switch 8.

A host computer 15 controls the shimming coils 2' as well as the gradient pulse amplifier 3 and the transmitter 7 to generate the imaging sequences of the invention. For the selected sequence, the receiver 14 receives signal data from a single or a plurality of k-space lines in rapid succession following each RF excitation pulse. A data acquisition system 16 performs analog-to-digital conversion of the received signals and converts each k-space line to a digital format suitable for further processing. In modern MR systems the data acquisition system 16 is a separate computer which is specialized in acquisition of raw image data.

Ultimately, the digital raw image data are reconstructed into an image representation by a reconstruction processor 17 which applies a Fourier transform or other appropriate reconstruction algorithms, such as SENSE. The MR image may represent a planar slice through the patient, an array of parallel planar slices, a three-dimensional volume, or the like. The image is then stored in an image memory where it may be accessed for converting slices, projections, or other portions of the image representation into appropriate format for visualization, for example via a video monitor 18 which provides a man-readable display of the resultant MR image.

The host computer 15 and the reconstruction processor 17 are configured, by corresponding programming, to perform the method of the invention described herein above and in the following.

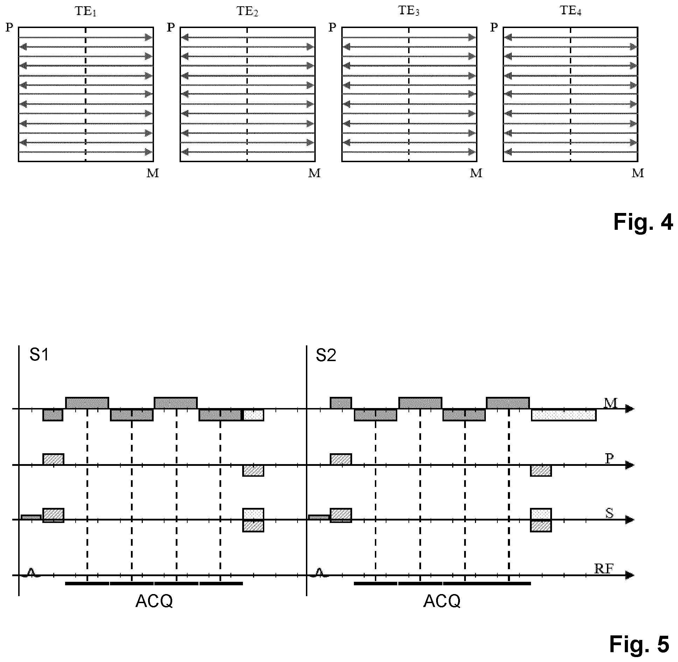

According to the invention, a multi-echo imaging sequence with bipolar readout gradients is used. The echo signals are acquired with different readout magnetic field gradient polarities for each echo time. This is shown in Fig. 4 illustrating the k-space sampling scheme according to the invention. Each depicted k-space line is associated with one acquired echo signal. Individual k-space sampling patterns are shown for the four echo times TE1, TE2, TE3, TE4. At each echo time, one half of the k-space lines in the frequency-encoding direction M is traversed in positive direction, whereas the other half is traversed in negative direction. Successive k-space lines have alternating readout directions in the phase-encoding direction P. K-space lines acquired with the same phase-encoding for successive echo times have opposite readout directions.

The corresponding imaging sequence is illustrated schematically in the pulse sequence diagram of Fig. 5. The diagram shows switched magnetic field gradients in the frequency-encoding direction (M), the phase-encoding direction (P) and the slice-selection direction (S). Moreover, the diagram shows the RF pulses as well as the time intervals during which echo signals are acquired, designated by ACQ. The four time intervals ACQ together constitute the readout period within the meaning of the invention. A number of echo signals (four in the depicted embodiment) is acquired in each readout period between two consecutive RF pulses using a series of bipolar readout magnetic field gradients. The four echo times are indicated by the vertical dashed lines. Fig. 5 covers the first two segments S1, S2 of the imaging sequence. A higher number of segments will be required in practice to apply the necessary phase-encodings for fully covering the pre-determined k-space region. As can be seen in Fig. 5, in order to obtain different readout polarities for each echo time, the polarity of all but the last magnetic field gradient lobe in M direction is reversed in the second (and every second following) segment S2. Additionally, the area of the last magnetic field gradient lobe in M direction is increased to preserve the integral over all gradient lobes in M direction in each segment.

The shown multi-echo acquisition scheme enables the estimation of amplitude and phase errors from the acquired echo signals for each individual echo time.

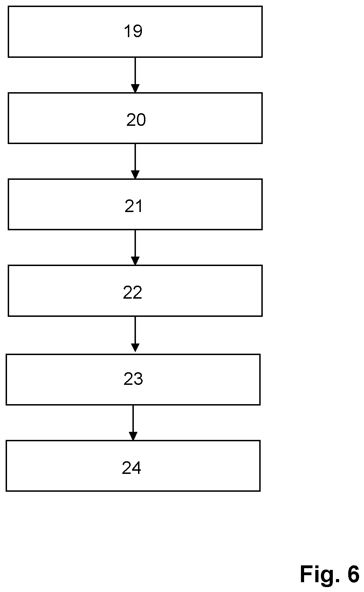

The course of the method according to an embodiment of the invention is illustrated in the flow-chart of Fig. 6:
In step 19, a pre-scan is performed to acquire a B0 map. Appropriate B0 mapping techniques are well-known as such in the art.
In step 20, the actual MR imaging is performed according to the method proposed by the invention (as explained herein above and illustrated in Figures 4 and 5).
In step 21, for each echo time, an individual MR image is reconstructed for each of the two (positive and negative) readout directions, resulting in an image pair for each echo time. B0 distortions are corrected in each individual MR image according to the B0 map acquired in step 19.
In step 22, again for each echo time, amplitude and phase errors caused by the bipolar readout are estimated from the respective pairs of individual MR images reconstructed in step 21. This can be achieved by aligning the voxel-wise phase and amplitude of the respective image pair for each echo time.
In step 23, one single-echo MR image is reconstructed for each echo time from the full echo data set, i.e. from the echo signals acquired in both positive and negative readout direction at the respective echo time. Again, distortions caused by B0 inhomogeneity are corrected on the basis of the B0 map acquired in step 19, and phase and amplitude errors caused by the bipolar readout are corrected based on the estimates derived previously in step 22 from the individual image pairs.
Finally, in step 24, post-processing is performed on the resulting series of single-echo MR images, e.g. involving a water/fat separation and/or a proton density fat fraction quantification in the manner well-known as such in the art. Bias is avoided therein because amplitude and phase errors related to the bipolar readout have been eliminated in step 24.

## Claims

1. Method of MR imaging of an object (10) placed in a main magnetic field B0, the method comprising the steps of
- subjecting the object (10) to an imaging sequence comprising multiple segments (S 1, S2), each segment comprising at least one RF pulse followed by a phase-encoding magnetic field gradient and a series of bipolar readout magnetic field gradients applied during a readout period,
- acquiring two or more phase-encoded echo signals during each readout period, each of the echo signals being associated with a different echo time resulting from the application of the series of bipolar readout magnetic field gradients, the phase-encoding and bipolar readout magnetic field gradients being controlled so as to sample a pre-determined k-space region with both positive and negative, i.e. opposite, readout directions for each echo time,
- estimating amplitude and/or phase errors from the echo signals acquired with opposite readout directions for each echo time, and
- reconstructing an MR image for each echo time involving correction of image distortions according to the estimated amplitude and/or phase errors.

2. Method of claim 1, wherein, for each echo time, the readout direction for sampling one half of the pre-determined k-space region is positive, while the readout direction for sampling the other half of the pre-determined k-space region is negative.

3. Method of claim 1 or 2, wherein the sampling of the pre-determined k-space region is performed for each echo time in such a way that the echo signals succeeding in the phase encoding direction have alternating positive and negative readout directions.

4. Method of any one of claims 1-3, wherein the phase-encoding and bipolar readout magnetic field gradients are controlled such that the echo signals acquired with the same phase-encoding for successive echo times have opposite readout directions.

5. Method of any one of claims 1-4, wherein the reconstructed MR images are exploited to perform a water/fat separation.

6. Method of any one of claims 1-5, wherein a susceptibility map is derived from the reconstructed MR images.

7. Method of any one of claims 1-6, wherein the reconstructed MR images are exploited to perform a proton density fat fraction quantification.

8. Method of any one of claims 1-7, further comprising a B0 mapping step, wherein the reconstruction of the MR images involves a correction of distortions arising from B0 inhomogeneity.

9. Method of any one of claims 1-8, wherein, for each echo time, an individual MR image is reconstructed for each readout direction, amplitude and/or phase errors being estimated from the resulting pair of MR images.

10. MR system comprising at least one main magnet coil (2) for generating a uniform, static magnetic field B0 within an examination volume, a number of gradient coils (4, 5, 6) for generating switched magnetic field gradients in different spatial directions within the examination volume, at least one RF coil (9) for generating RF pulses within the examination volume and/or for receiving MR signals from an object (10) positioned in the examination volume, a control unit (15) for controlling the temporal succession of RF pulses and switched magnetic field gradients, and a reconstruction unit (17) for reconstructing MR images from the received MR signals, wherein the MR system (1) is configured to perform the steps of the method of any one of claims 1-9.

11. Computer program comprising instructions which, when executed by a control unit (15) of an MR system (1), cause the MR system (1) to carry out the following steps:
- performing an MR imaging sequence comprising multiple segments, each segment comprising an RF pulse followed by a phase-encoding magnetic field gradient and a series of bipolar readout magnetic field gradients applied during a readout period, and
- acquiring two or more phase-encoded echo signals during each readout period, each of the echo signals being associated with a different echo time resulting from the application of the series of bipolar readout magnetic field gradients, the phase-encoding and bipolar readout magnetic field gradients being controlled so as to sample a pre-determined k-space region with both positive and negative, i.e. opposite, readout directions for each echo time.

12. Computer program comprising instructions which, when executed by a computer, in particular by a reconstruction unit (15) of an MR system (1), cause the computer to estimate amplitude and/or phase errors from echo signals acquired at different echo times and sampling a pre-determined k-space region with both positive and negative, i.e. opposite, readout directions for each echo time, and to reconstruct an MR image for each echo time involving correction of image distortions according to the estimated amplitude and/or phase errors.
